# EUROPEAN PATENT APPLICATION

(11) **EP 4 531 353 A1**
(43) Date of publication of application: **02.04.2025**
(21) Application number: 23306608.3
(22) Date of filing: 27.09.2023
(51) Int. Cl.: H04L 25/02, G01R 31/382, H01M 6/50, H01M 10/48, H01M 10/60, H04B 1/7163, H04B 1/717, H04B 17/00

(54) **SYSTEM AND METHOD**

(71) Applicant: NXP B.V., 5656 AG Eindhoven (NL)
(72) Inventor: Ridolfi, Matteo, 5656 AG Eindhoven (NL); Brink, Klaas, 5656 AG Eindhoven (NL); Martinez, Vincent Pierre, 31023 Toulouse, Cedex 1 (FR); Casamassima, Filippo, 5656 AG Eindhoven (NL); Moerman, Cornelis Marinus, 5656 AG Eindhoven (NL)
(74) Representative: Schmütz, Christian Klaus Johannes

(57) **Abstract**

The present invention relates to a system and method for determining of a mechanical deformation of a battery based on an influence on an ultra wideband, UWB, signal 120, which is transmitted between two UWB units of the system, where one of the UWB units is part of a control module of the system, wherein the control module also comprising a control unit being configured to be connected to a battery cell 116 of the battery 118 for controlling and/or monitoring the battery cell 116.

## Description

### TECHNICAL FIELD

The present disclosure relates to a system and a method.

### BACKGROUND

Batteries are often used in vehicles or in other technical devices. Such a battery comprises a plurality of battery cells, which may also be referred to as cells. The battery cells of the battery may be coupled in series, in parallel, or in a mixture of both. By coupling a plurality of battery cells in a battery, a desired electrical voltage, a desired electrical capacity, and/or a desired electrical power density can be achieved. A battery having a plurality of battery cells may also be referred to as a battery pack.

Each battery cell may be charged, discharged, and/or recharged many times. For example, a battery cell may be a lithium-ion battery cell. However, there are many other types and/or configurations of battery cells, such as those with different electrical materials for the electrodes and/or electrolytes. Due to very small manufacturing differences and due to different electrical and/or thermal loads, a change in electrical capacity, other electrical properties and/or mechanical properties of a battery cell may occur. To monitor a change in chemical and/or electrical properties, each battery cell of a battery can be monitored by a dedicated, associated unit. This unit may also be referred to as a cell control unit.

A battery may comprise a plurality of battery cells. A battery management system may be coupled to the battery and comprise a corresponding plurality of cell control units. Each battery cell of the battery may be coupled to a dedicated, associated cell control unit of the battery management system. Each battery cell may thus be monitored and/or controlled by the respective associated cell control unit.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

Aspects of the disclosure are defined in the accompanying claims.

According to a first aspect of the present disclosure, a system is provided. The system comprises a first control module and a second control module, wherein the first control module comprises a first control unit and an ultra wideband communication unit, referred to as a first UWB unit, wherein the second control module comprises a second control unit and an ultra wideband communication unit, referred to as a second UWB unit, wherein one of the control modules is referred to as a cell control module and is configured such that the associated control unit can be coupled to a first battery cell of a battery to monitor and/or control the voltage and/or temperature of the battery cell, wherein the second control module is configured to transmit a first ultra wideband radio signal, referred to as first UWB signal, from the second UWB unit to the first UWB unit, wherein the first UWB signal represents a first data frame comprising at least a first predefined synchronization field, a first predefined start of frame delimiter, SFD, field, a first payload field, and particularly a first scrambled timestamp sequence, STS, field and/or a first physical layer header, PHR, field, wherein the first control module is configured to determine a first channel impulse response, CIR, based on a component of the received first UWB signal representing at least one symbol of at least one of the first synchronization field, the first SFD field, and particularly the first STS field and/or the first PHR field, wherein a first reference CIR is stored by the first control module, and wherein the first control module is configured to determine a first deformation of the battery based on the first CIR and the first reference CIR. The first predefined synchronization field may also be referred to as first preamble or first preamble field. The first payload field may also be referred to as first PSDU. Together, the first predefined synchronization field and the first predefined SFD field may also be referred to as the first synchronization header or first SHR field.

In one or more embodiments, the first deformation of the battery refers to a deflection of the battery, a twisting of the battery, a concave or convex deformation of an outer side of the battery, and/or a volume change of the battery.

In one or more embodiments, the first control module is configured to compare the first CIR with the first reference CIR resulting in a first comparison result, and wherein the first control module is configured to determine the first deformation of the battery based on the first comparison result.

In one or more embodiments, the first control module is configured to determine a first difference between the first CIR and the first reference CIR, and to determine the first deformation of the battery based on the first difference.

In one or more embodiments, a first machine learning, ML, network is implemented to the first control module, the first ML network being pre-trained with training reference impulse responses and training impulse responses to determine training deformations of the battery, respectively, wherein the first control module is configured to supply the first CIR and the first reference CIR to the first ML network and to determine the first deformation of the battery via the first ML network based on the supplied first CIR and the supplied first reference CIR.

In one or more embodiments, the first control module is configured to identify the battery as being in a first state if the determined first deformation is less than a predefined first reference deformation threshold, and wherein the first control module is configured to identify the battery as being in a second state if the determined first deformation is greater than the predefined first reference deformation.

In one or more embodiments, the first control module is configured to generate a signal referred to as a first error signal if the second condition is identified, and wherein the first control module is configured to transmit the first error signal to a supervisory control module via the first UWB unit.

In one or more embodiments, the first and second control modules are configured to transmit another UWB signal, referred to as a reference UWB signal, from the second UWB unit to the first UWB unit, wherein the reference UWB signal represents a data frame referred to as a reference data frame, which comprises at least the first predefined synchronization field and/or the first SFD field and/or particularly the first STS field, wherein the first control module is configured to determine the first reference CIR based on a component of the received reference UWB signal representing at least one symbol of at least one of the first synchronization field, the first SFD field and particularly the first STS field, and wherein the first control module is configured to store the first reference CIR.

In one or more embodiments, the second control module forms the cell control module.

In one or more embodiments, the system comprises a third control module being particularly identical to the second control module, wherein the second control module forms a cell control module referred to as a second cell control module, which comprises the second control unit being adapted to be coupled to a first battery cell of the battery, wherein the third control module forms another cell control module referred to as a third cell control module, which comprises a third control unit being adapted to be coupled to a second battery cell of the battery, wherein the first control module and third control module are configured to transmit a second UWB signal from the third UWB unit of the third control modules to the first UWB unit of the first control module, wherein the second UWB signal represents a second data frame comprising at least a second predefined synchronization field, a second predefined SFD field, a second payload field, and particularly a second STS field, wherein the first control module is configured to determine a second CIR based on a component of the received second UWB signal representing at least a symbol of at least one of the second synchronization field, the second SFD field, and particularly the second STS field, wherein a second reference CIR is stored by the first control module, and wherein the first control module is configured to determine a second deformation of the battery based on the second CIR and the second reference CIR.

In one or more embodiments, the first control module is configured to discard the first deformation if the first deformation deviates from the second deformation by more than a predefined deformation threshold.

In one or more embodiments, the first control module comprises a wired communication unit.

In one or more embodiments, a CAN protocol, an Ethernet protocol, or another wired communication protocol is implemented by the wired communication unit.

In one or more embodiments, the system comprises the battery.

According to a second aspect of the present disclosure, a method for a system is provided, where the system comprising a first control module and a second control module, the first control module comprising a first control unit and an ultra wideband communication unit referred to as a first UWB unit, the second control module comprising a second control unit and an ultra wideband communication unit, referred to as a second UWB unit, wherein one of the control modules is referred to as a cell control module and is configured so that the associated control unit can be coupled to a first battery cell of a battery, wherein a first reference impulse response is stored by the first control module, and wherein the method comprises the steps of: a) Transmitting a first UWB signal from the second UWB unit to the first UWB unit, wherein the first UWB signal represents a first data frame comprising at least a first synchronization field, a first start of frame delimiter, SFD, field, a first payload field, and particularly a first scrambled timestamp sequence, STS, field; b) Determining, by the first control module, a first channel impulse response based on a component of the received first UWB signal representing at least a symbol of at least one of the first synchronization field, the first SFD field, and particularly the first STS field; and c) Determining a first deformation of the battery based on the first channel impulse response and the first reference impulse response by the first control module.

In accordance with a further aspect of the present disclosure, a computer program is provided, comprising executable instructions which, when executed by a processing unit, cause the processing unit being configured to carry out the method of the second aspect and/or one or more embodiments thereof.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figure 1 shows a simplified block diagram of an embodiment of the system.
Figure 2 shows a simplified block diagram of a data frame.
Figure 3 shows a simplified signal chart of examples of channel impulse responses.
Figure 4 shows a simplified signal chart of an example of a difference between channel impulse responses.
Figure 5 shows a simplified flow chart of an embodiment of the method.

### DESCRIPTION OF EMBODIMENTS

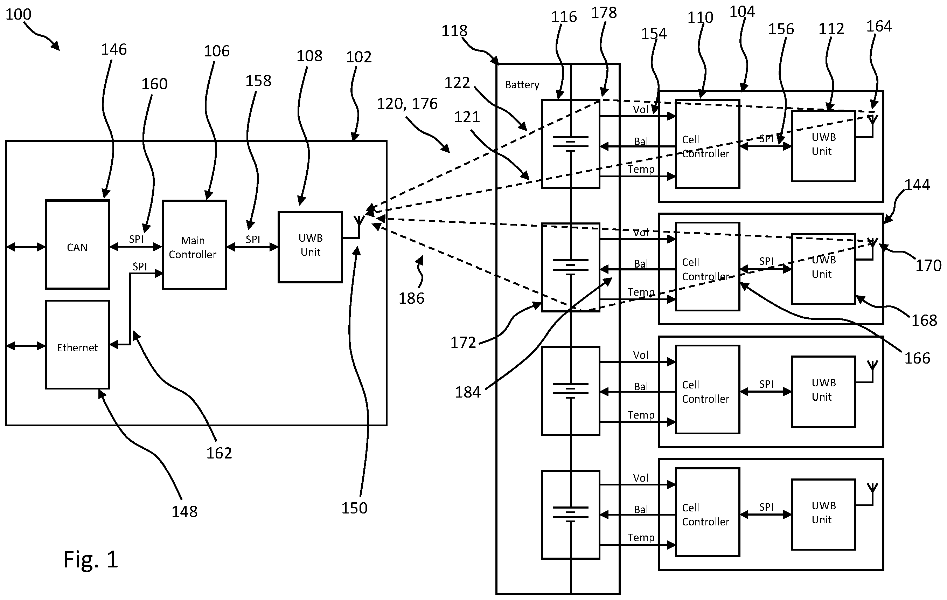

Figure 1 schematically illustrates an example of a battery 118. The battery 118 comprises a plurality of battery cells 116, 172. In an example, the battery cells 116, 172 may be connected in series.

The electrical properties of each battery cell 116, 172 may change due to electrical and/or thermal stress. In addition, the electrical properties of each battery cell 116, 172 may change due to a mechanical deformation of the respective battery cell 116, 172. In an example, a mechanical deformation of a battery cell 116, 172 may change the electrical capacity of the respective battery cell 116, 172. For example, if a battery cell 116, 172 is mechanically bent, then most likely the electrical capacity of the battery cell 116, 172 will decrease. To ensure high electrical efficiency and/or to ensure a low failure rate of a battery 118, it is desirable to be able to detect as early as possible a mechanical deformation of the battery 118, in particular of an associated battery cell 116, 172, during a use of the battery 118 without having to interrupt the use of the battery 118. An early detection would allow to save costs. At the same time, it is desirable to have a high power density for the battery 118.

Figure 1 also schematically illustrates an example embodiment of a system 100. The system 100 comprises a first control module 102 and a second control module 104. The first control module 102 comprises a first control unit 106 and an ultra wideband communication unit 108, referred to as the first UWB unit 108. The second control module 104 comprises a second control unit 110 and an ultra wideband communication unit 112, referred to as the second UWB unit 112. A control module of the two control modules 102, 104 may be referred to as a cell control module 102, 104. The control unit 106, 110 of the cell control module 102, 104 may also be referred to as the control unit 106, 110 associated with the cell control module 102, 104. In an example, the second control module 104 may be the cell control module 104. In this example, the cell control module 104 comprises the second control unit 110. In other word, in this example, the second control unit 110 is associated with the cell control module 104. The cell control module 104 may be configured such that the control unit 110 of the cell control module 104 may be coupled to a first battery cell 116 of the battery 118. The cell control module 104 may further be configured to measure, monitor, and/or control an electrical voltage and/or a temperature of the first battery cell 116 via the coupling to the first battery cell 116.

As mentioned previously, in an example, the second control module 104 may form the cell control module 104. In this example, the cell control module 104 may also be referred to as the second cell control module 104. The second control module 104 may be coupled to the first battery cell 116 to, for example, measure, monitor, and/or control an electrical voltage of the battery cell 116. In an example, at least one electrical wired signal connection 154 may extend from the second control unit 110 to the first battery cell 116. The at least one electrical signal connection 154 may form a coupling between the second control unit 110 and the first battery cell 116. Alternatively and/or complementarily, the second control unit 110 may be coupled to the first battery cell 116 via the at least one electrical signal connection 154 to measure a temperature of the first battery cell 116.

To detect a mechanical deformation of the first battery cell 116, for example, a pressure sensor and/or a mechanical strain sensor could be integrated into the first battery cell 116 and/or attached to an exterior of the battery cell 116. If present, the pressure sensor and/or the strain sensor could detect a mechanical deformation of the first battery cell 116 during operation of the battery cell 116. A signal representing the sensed pressure and/or the sensed strain may be transmitted between the respective sensor and the first control unit 110 via the at least one electrical connection 154.

The integration of a pressure sensor and/or a strain sensor in the first battery cell 116 has the disadvantage that the pressure sensor and/or the strain sensor requires a certain installation space in the first battery cell 116, so that the power density of the battery cell 116 decreases due to the integration of a pressure sensor and/or a strain sensor. In particular, the strain sensor also has the disadvantage that the strain sensor, such as a strain gauge, can only measure the strain on one side of the battery cell 116. Such strain sensors raise the costs. If the battery cell is deformed by compression, the strain gauge is often not suitable for detecting such deformation of the battery cell 116 because the strain sensor can only detect strain, not compression. A similar disadvantage can occur when using a strain gauge if the deformation of the battery cell 116 does not occur in the area of the strain gauge, but at another location on the battery cell 116. For example, if the battery cell 116 is depressed by a mechanical impact from the outside at a location where the strain gauge is not attached, the strain gauge will not be able to detect such a deformation of the battery cell 116 caused by a mechanical impact. Mechanical deformations to the battery cell that do not result in an increase in a pressure within the battery cell 116 often cannot be detected by a pressure sensor.

Against this background, it is desirable to be able to detect a mechanical deformation of a battery cell 116, 172 of a battery 118 without having to integrate a sensor into the battery cell 116, 172 to measure the mechanical deformation of the battery cell 116, 172.

The first control module 102 and/or the second control module 104 are configured to transmit a first ultra wideband radio signal 120, also referred to as a first UWB signal 120, from the second UWB unit 112 to the first UWB unit 108. In an example, the second control module 104 may be configured to control and/or cause the second UWB unit 112 to transmit the first UWB signal 120 from the second UWB unit 112 to the first UWB unit 108. As will be discussed further below, the first UWB signal 120 may be used to determine a mechanical deformation of the first battery cell 116. Therefore, determining the mechanical deformation of the first battery cell 116 does not require a dedicated sensor within the battery cell 116, such as a pressure sensor or a strain gauge. Using the first UWB signal 120 to determine any mechanical deformation of the first battery cell 116 has the advantage of (continuing to) provide high power density to the first battery cell 116. Furthermore, any mechanical deformation of the battery 118 can be determined by using the first UWB signal 120. The first UWB signal 120 may be a UWB signal that is exchanged between the second and first UWB units 112, 108 anyway. As an effect, there is no interruption of regular operation. Further, there is also no adverse effect on regular operation.

In an example, the second UWB unit 112 may be configured to send the first UWB signal 120. Further, the first UWB unit 108 may be configured to receive the first UWB signal 120. In an example, the first UWB signal 120 is a UWB signal according to the IEEE 802.15.4z standard, particularly the version 2020.

In an example, the second control unit 110 may be coupled to the first battery cell 116 via the at least one signal connection 154 to measure, monitor, and/or adjust an electrical voltage of the first battery cell 116. Alternatively or additionally, the second control unit 110 may be coupled to the first battery cell 116 via the at least one signal connection 154 to measure a temperature of the first battery cell 116. The second control unit 110 may further be coupled to the second UWB unit 112 via another signal connection 156. The second control unit 110 may be configured to control the second UWB unit 112 via the signal connection 156. In an example, the second control unit 110 may control the second UWB unit 112 such that the second UWB unit 112 generates the first UWB signal 120 and/or transmits the first UWB signal 120 to the first UWB unit 108, wherein the first UWB signal 120 represents a sensed voltage of the first battery cell 116 and/or a sensed temperature of the first battery cell 116.

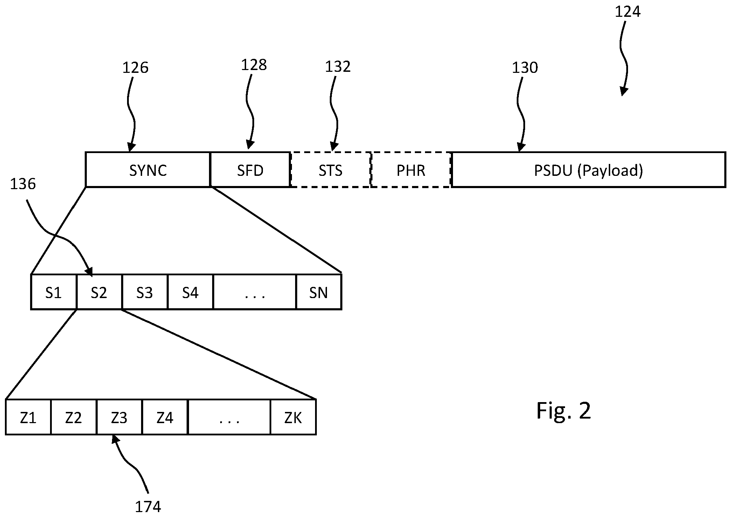

The first UWB signal 120 represents a first data frame 124. Figure 2 schematically illustrates an embodiment of the first data frame 124. The first data frame 124 comprises a first predefined synchronization field 126, a first predefined start-of-frame delimiter, SFD, field 128, and a first payload data field 130. The first data frame 124 may comprise at least one other field, such as a first scrambled timestamp sequence, STS, field 132 and/or at least one other field.

Each field 126, 128, 130, 132 of the first data frame 124 comprises at least one symbol. For example, the first synchronization field 126 may comprise multiple symbols 136. Each symbol comprises a plurality of bits 174. With respect to the structure of the fields 126, 128, 130, 132 and/or the purpose of the fields 126, 128, 130, 132, reference is made in an example to the IEEE 802.15.4z standard, in particular version 2020.

The bits 174 may be transmitted via the UWB signal, in particular the first UWB signal 120, each in the form of a single impulse. Each impulse may have the same impulse shape, in particular similar to a Gaussian impulse. For each bit 174 of the data frame 124, there may be a unique point in time during the transmission of a UWB signal, in particular the first UWB signal 120. Depending on a phase rotation of 180°, bit value 1 may be represented by the impulse or bit value -1 may be represented by the impulse rotated by 180°. If the impulse is not transmitted at the time intended for the impulse, then the bit value 0 is represented.

An impulse of the first UWB signal 120 may have a very short duration, such as a time duration of less than 20 nanoseconds, ns, less than 10 ns, or less than 5 ns. In an example, an impulse may be understood as a very short radio signal. A radio signal can also be understood as an electromagnetic wave that propagates in different directions in space when sent. In an example, each UWB unit 108, 112 may comprise an associated antenna 150, 164. For example, the second UWB unit 112 may comprise the second antenna 164. Starting from the second antenna 164, an impulse of the first UWB signal 120 may propagate, for example, in multiple spatial directions, for example reflecting on surfaces and yet reaching the receiver antenna, resulting in multiple transmission paths 121, 122 (sometimes also referred to as multipaths). Along a first transmission path 121 (which can be a direct path), the impulse of the first UWB signal 120 may encounter multiple objects, such as the second UWB unit 112, the second control unit 110, and the first battery cell 116. Depending on the nature of each object, the impulse of the first UWB signal 120 may be attenuated along the first transmission path 121. Along a second transmission path 122, the impulse of the first UWB signal 120 may not only be attenuated, but the impulse may also be reflected, for example, at the first battery cell 116. Due to the reflection, the impulse of the first UWB signal 120 reaches the first UWB unit 108 not only along the first transmission path 121 but also along the second transmission path 122. The first and second transmission paths 121, 122 are only exemplary transmission paths. In fact, other and/or a greater number of transmission paths 121, 122 may exist between the second UWB unit 112 and the first UWB unit 108. Due to the different distances travelled by the impulse of the first UWB signal 120 via the different transmission paths 121, 122, the impulse of the first UWB signal 120 reaches the second UWB unit 108 at different reception times. Due to the very short duration of the impulse of the first UWB signal 120, the impulse may be received multiple times via the multiple transmission paths 121, 122 at the different or similar reception times, but each time with a different signal strength. Often, a transmission time of the impulse along two or more transmission paths of the multiple transmission paths 121, 122 is about the same, such that it may be considered that the impulse can arrive multiple times at about the same reception time. If the impulse arrives via several transmission paths at approximately the same reception time, they can add the corresponding signal strengths. The reception times are also referred to as "bins". In an example, the signal strength of an impulse of the first UWB signal 120 detected at a plurality of successive reception times represents a channel impulse response, CIR. The number of reception times may be predefined. In an example, the number of reception times is sixty-four (64). An impulse of the first UWB signal 120 may be sampled at a fixed frequency by the first UWB unit 108. At each sample the signal strength of the impulse is detected at the respective reception time.

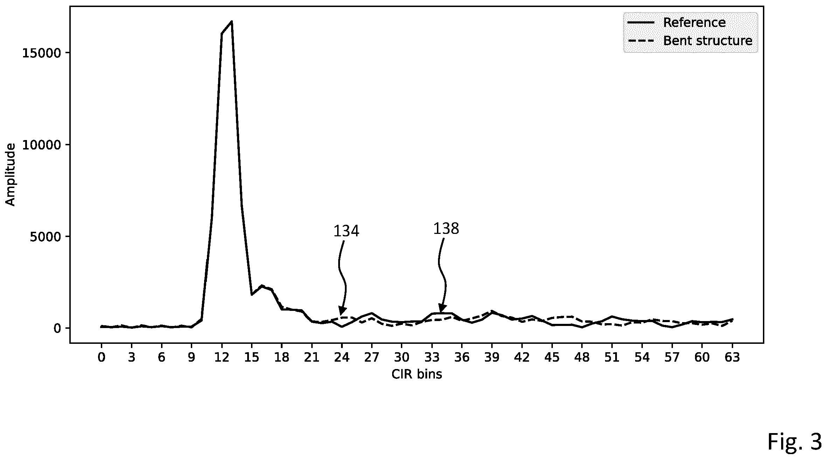

In Figure 3, an example of the amplitude of a channel impulse response, referred to as the first reference channel impulse response 138, is schematically shown by the solid line. In Figure 3, another example of the amplitude a channel impulse response referred to as a first reference channel impulse response 134 is schematically shown by the dashed line. In the sections where the dashed line is not visible, the dashed line is covered by the solid line.

For the first reference channel impulse response 138, in an example, it is to be assumed that the battery 118, and particularly also the first and/or second battery cell 116, 172, is not and/or has not been subjected to mechanical deformation, but that the battery 118, and particularly also the first and/or second battery cell 116, 172, is, for example, in a new condition. If an impulse of another UWB signal 176, referred to as a reference UWB signal, is generated by the second UWB unit 112, wherein each impulse of the reference UWB signal 176 may be transmitted by the second UWB unit 112 and may be received by the first UWB unit 108 via a plurality of transmission paths 121, 122, sometimes also referred to as multipaths. In an example, the impulse of the reference UWB signal 176 along the transmission path 121 is not reflected but is attenuated due to the multiple objects, such as the first battery cell 116. In an example, the impulse of the first reference UWB signal 176 along the transmission path 122 is reflected at the location 178 of the first battery cell 116.

The first UWB unit 108 may detect the signal strength of the impulse of the first reference UWB signal 176 at, for example, sixty-four (64) consecutive reception times. The resulting channel impulse response may be, in an example, the first reference channel impulse response 138 as schematically represented by the solid line in Figure 3. The signal strength (amplitude) is particularly large at the 12^{th} and 13^{th} reception times (12^{th} and 13^{th} CIR bin). In an example, the signal strength at the 12^{th} reception time may be caused by the impulse of the first reference UWB signal 176 transmitted along the transmission path 121 from the second UWB unit 112 to the first UWB unit 108. The transmission path 121 may be a direct transmission path. In an example, the signal strength at the 24^{th} reception time (24^{th} CIR bin) may be caused by the impulse of the first reference UWB signal 176 transmitted on the transmission path 122 from the second UWB unit 112 to the first UWB unit 108.

For the first channel impulse response 134, it is to be assumed in an example that at least the first battery cell 116 of the battery 118 is mechanically deformed, such as bent by a mechanical external action. It is noted that the deformation of the first battery cell 116 is not shown in the schematic diagram in Fig. 1. If an impulse of a first UWB signal 120 is generated by the second UWB unit 112, the impulse of the first UWB signal 120 may be transmitted to the first UWB unit 108 via a plurality of transmission paths 121, 122. The first UWB unit 108 may detect the signal strength of the impulse of the first UWB signal 120 at, for example, sixty-four (64) consecutive reception times. In an example, the resulting channel impulse response may be the first channel impulse response as schematically represented by the dashed line in Figure 3. The signal strength (amplitude) is particularly large at the 12^{th} and 13^{th} reception times (12^{th} and 13^{th} CIR bin). In an example, the signal strength at the 12^{th} reception time may be caused by the impulse of the first UWB signal 120 transmitted along the transmission path 121 from the second UWB unit 112 to the first UWB unit 108. Due to the mechanical deformation of the first battery cell 116, in an example, it may be assumed that the attenuation of the impulse of the first UWB signal 120 along the transmission path 121 does not change, at least substantially. In an example, the signal strength at the 24^{th} reception time (24^{th} CIR bin) may be caused by the impulse of the first UWB signal 102 transmitted along the transmission path 122 from the second UWB unit 112 to the first UWB unit 108. In an example, the impulse of the first UWB signal 120 along the transmission path 121 is not reflected but is attenuated due to the plurality of objects, such as the first battery cell 116. In an example, the impulse of the first UWB signal 120 along the transmission path 122 is reflected at the location 178 of the first battery cell 116.

The mechanical deformation may, in an example, increase the density of the material at a location 178 of the first battery cell 116. The increased density at the location 178 causes the impulse of the first UWB signal 120 at the first location 178 to be less attenuated as compared to the non-deformed and/or non-compacted location 178. The increased density at the location 178 (due to the mechanical deformation of the first battery cell 116) causes that the signal strength at the 24^{th} reception time (24. CIR bin) of the first channel impulse response 134 is greater than the signal strength at the 24^{th} reception time of the first reference channel impulse response 138. Based on the signal strength of the first channel impulse response 134 and the signal strength of the first reference channel impulse response 138, it is therefore possible to infer whether the battery 118, in particular the associated first battery cell 116, is mechanically deformed. If there is no difference between the signal strength of the first reference channel impulse response 138 and the signal strength of the first channel impulse response 134, in particular no difference at any reception time, then the battery 118, in particular the associated first battery cell 116, is not mechanically deformed. However, if for at least one reception time the signal strength of the first channel impulse response 134 differs from the signal strength of the first reference channel impulse response 138 by more than a predefined threshold 180, then the battery 118, in particular the associated first battery cell 116, is mechanically deformed.

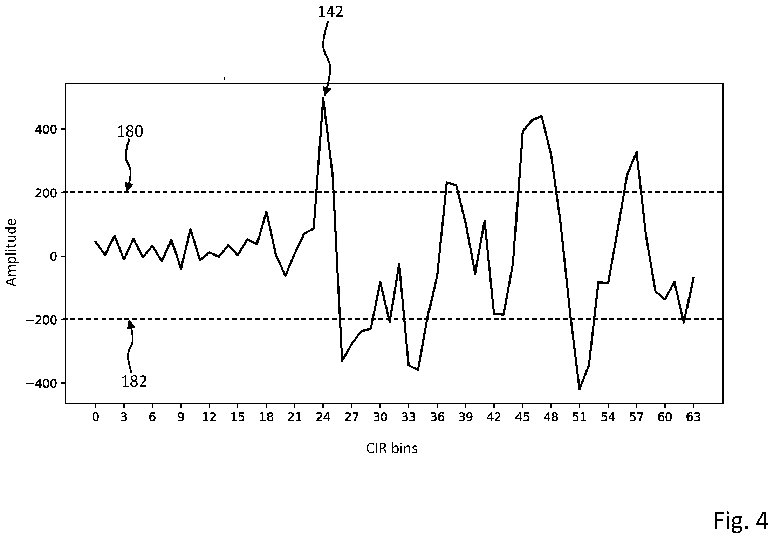

In Figure 4, an example of the difference 142 between the signal strength (amplitude) of the first reference channel impulse response 138 and the signal strength (amplitude) of the first channel impulse response 134 is plotted over the plurality of reception times. The difference 142 between the signal strengths may also be referred to as the signal strength (amplitude) difference 142. In an example, a deformation of the battery 118, particularly a deformation of the first battery cell 116, may be assumed to exist if the signal strength difference 142 is either greater than a first threshold value 180 or less than a second threshold value 182. The first threshold value 180 may be a predefined positive value. The second threshold value 182 may be a predefined negative value. In an example, it may be assumed that there is no deformation of the battery 118, in particular no deformation of the first battery cell 116, if the signal strength difference 142 is less than the first threshold value 180 and greater than the second threshold value 182.

In the example shown in Fig. 4, the signal strength difference 142 at the 24^{th} reception time (24^{th} CIR bin) is greater than the first threshold 180, so that in this example it can be assumed that the battery 118, in particular the associated first battery cell 116, is deformed. If, in an example not shown in Fig. 4, the signal strength difference 142 would not be greater than the first threshold 180 or less than the second threshold 182 at any of the reception times, but would be between the two thresholds 180, 182 at each reception time (not shown in Fig. 4), then it could be inferred from the signal strength difference 142 that the battery 118, in particular the associated first battery cell 116, is not deformed.

In an example, the first control unit 106 is coupled to the first UWB unit 108. A signal connection 158 may extend from the first UWB unit 108 to the first control unit 106. The signal connection 158 may form the coupling between the first control unit 106 and the first UWB unit 108. The first UWB unit 108 may be configured to transmit a signal, referred to as a detection signal, to the first control unit 106, particularly via the signal connection 158. The first UWB unit 108 may generate the detection signal such that the detection signal represents the signal strength of a UWB signal 120, 176 detected at the receiving times.

The first control module 102, particularly the associated first control unit 106, is configured to determine the first channel impulse response 134 based on a first component of the received, first UWB signal 120. The first component of the first UWB signal 120 represents at least one symbol 136 of at least one of the following fields 126, 128, 132 of the first data frame 124: first synchronization field 126, first SFD field 128, and particularly first STS field 132. The first data frame 124 is represented by the first UWB signal 120. In an example, the first control module 102, in particular the first control unit 106, may determine the first channel impulse response 134 from exactly one symbol 136 from only one field, such as the synchronization field 126.

The first reference channel impulse response 138 may be stored by the first control module 102, particularly by the associated first control unit 106. The first reference channel impulse response 138 may have been previously determined in the same manner as the first channel impulse response 134. For determining the first reference channel impulse response 138, it is ensured that the battery 118, in particular the first battery cell 116, is not deformed, but is particularly in a new condition.

For determining the first channel impulse response 134, the first component of the first UWB signal 120 representing at least one symbol 136 of only certain fields 126, 128, 132 of the first data field 124 is used. Only the first synchronization field 126, the first SFD field 128, and particularly the first STS field 132 are allowed. Components other than the aforementioned first component of the first UWB signal 120 are particularly not used to determine the first channel impulse response 134. By restricting the first component to the at least one symbol 136 of the allowable fields 126, 128, 132, it can be ensured that the at least one symbol 136 is predefined. For example, the first synchronization field 126 comprises predefined symbols 136, which may form and/or also be referred to as a predefined symbol sequence. In an example, the first SFD field also comprises predefined symbols. To the contrary, the symbols and/or bits of the data field 130 of the first data frame 124 may differ from first data frame 124 to first data frame 124. Consequently, in the case of multiple first data frames 124, it may be ensured that each first data frame 124 comprises the same, first synchronization field 126. A symbol 136 of the first synchronization field 126 is therefore particularly well suited and reliable for repeatedly determining the first channel impulse response 134 in a comparable manner. The same may be true for a symbol of the SFD field 128 or a symbol of the STS field 132. This first channel impulse response 134 may be compared to the first reference channel impulse response 138 to reliably determine whether the battery 118, in particular the associated first battery cell 116, is deformed based on the comparison result.

The first control module 102, in particular the associated control unit 106, is configured to determine a first deformation of the battery 118, in particular of the associated first battery cell 116, based on the first channel impulse response 134 and the reference impulse responses 138. In an example, the first deformation may relate to a state of potential deformation of the battery 118, particularly the associated first battery cell 116. In this example, the first deformation may represent either a "not deformed" status or a "deformed" status. In an example, the first control module 102, in particular the associated control unit 106, may perform the previously explained comparison between the first reference channel impulse response 138 and the first channel impulse response 134. Further, the first control module 102, in particular the associated control unit 106, may be configured to determine the first deformation of the battery 118, in particular the associated first battery cell 116, based on the comparison result. In an example, the first control module 102, in particular the associated control unit 106, may be configured to determine a "deformed" status for the first deformation if the comparison result indicates that the signal strength difference 142 is either greater than the first threshold 180 or less than the second threshold 182 for at least one reception time. Further, the first control module 102, in particular the associated control unit 106, may be configured to determine a "not deformed" status for the first deformation if the comparison result indicates that the signal strength difference 142 is less than the first threshold value 180 and greater than the second threshold value 182 for each reception time.

In an example, the second control unit 110 is configured as a battery control unit 110. Via the at least one signal connection 154, the second battery control unit 110 may be coupled to the first battery cell 116 to detect, monitor, and/or control an electrical voltage of the battery cell 116. In an example, the second battery control unit 110 may be configured and/or used to balance the electrical voltage of the first battery cell 116. Balancing the electrical voltage of the first battery cell 116 is particularly relevant when charging or discharging the first battery cell 116. Against this background, the second battery control unit 110 may control the electrical voltage of the first battery cell 116 in particular during charging or during discharging of the first battery cell. Alternatively or additionally, the second battery control unit 110 may be configured to measure a temperature of the first battery cell 116 via the at least one signal connection 154.

The second control module 104 comprises the second control unit 110, which is configured in particular as the second battery control unit 110, and the second UWB unit 112, which is particularly associated with the second antenna 164. The second control module 104 may also be referred to and/or configured as the second battery management unit 104 or the second battery management module 104. In this case, the management function is provided at least substantially by the second control unit 110. In an example, the second UWB unit 112 may receive a UWB signal comprising control instructions for the second control unit 110. These control instructions may be transmitted from the second UWB unit 112 to the second control unit 110 via the signal connection 156. The second control unit 110 may be configured to control a voltage of the first battery cell based on a measured voltage and/or the control instructions. The voltage and/or temperature sensed by the second control unit 110 may be represented by measurement data. In an example, it is (alternatively and/or also) possible for the second control unit 110 to control the second UWB module 112 via the signal connection 156 such that the second UWB module 112 transmits a UWB signal, in particular the first UWB signal 120, representing the measurement data via the associated antenna 164. The measurement data may be comprised by the payload data field 130.

In an example, the battery 118 comprises the first battery cell 116 and at least one other battery cell, such as the second battery cell 172. The battery cells 116, 172 of the battery 118 may be connected in series. The second control module 104 may be connected to the first battery cell 116 via the at least one signal connection 154. The system 100 may comprise at least one other control module, such as the third control module 144. The third control module 144 may be configured identically to the second control module 104. For the third control module 144, reference is made to the preceding and/or following explanations, preferred features, technical effects and/or advantages in an analogous manner as explained for the second control module 104. The control unit 166 of the third control module 144 is referred to as the third control unit 166. The UWB unit 168 of the third control module 144 is referred to as the third UWB module 168. The third UWB module 168 may have associated therewith the third antenna 170.

The first control module 102 may be configured to control and/or monitor at least one other control module, such as the second control module 104 and/or the third control module 144, and/or to control and/or monitor at least one battery cell 116, 172 via the at least one other control module 104, 144. The first control module 102 may therefore also be referred to and/or configured as a central management module 102 or a central management device 102.

In an example, the system 100 may be referred to and/or configured as a battery management system 100. In an example, the system 100 is a battery management system 100 if the first control module 102 is a central management module 102 and the further control modules 104, 144 are each configured as a battery management module 104, 144.

Deformation of a battery cell 116, 172 may be caused by external mechanical action, by internal electrical and/or electrochemical processes, and/or by other causes. The deformation of the battery cell 116, 172 may change the physical shape of the respective battery cell 116, 172. In an example, the battery cell 116, 172 may comprise plastic changes on the exterior, such as inwardly or outwardly facing dents, due to the possible deformation. Deformation of the battery cell 116, 172 may also relate to a change, particularly a local change, in the material density of the battery cell 116, 172. Due to the deformation of the battery cell 116, 172, the volume of the battery cell 116, 172 may further change, such as decrease or increase. A mechanical action on a battery cell 116, 172 often results in a concave change on an outer surface of the battery cell 116, 172. A concave change may also be referred to as a concave deformation of an outer surface of the battery cell 116, 172. Alternatively or additionally, an external mechanical action on the battery cell 116, 172 may result in the battery cell 116, 172 being bent by the mechanical action. The bent of the battery cell 116, 172 may relate to another example of the deformation of the battery 118.

Against this background, it is preferred that the first deformation of the battery 118 refers to a plastic deformation of the battery, such as a bending or deflection of the battery, a twisting of the battery, a concave deformation of an outer side of the battery, a convex deformation of an outer side of the battery, and/or a volume change of the battery.

In an example, the second control unit 110 of the second control module 104 is configured to be coupled to the first battery cell 116. When the coupling between the second control unit 110 and the first battery cell 116 is established, for example, by the at least one signal connection 154, it can be assumed that the second control module 104 is disposed in close proximity to the first battery cell 116. Due to the proximity between the second control module 104 and the first battery cell 116, it can further be assumed that the second UWB unit 112 comprises a small distance, in particular less than 30 cm, to the first battery cell 116. The second UWB unit 112 is configured to generate the first UWB signal 120 that is transmitted from the second UWB unit 112 to the first UWB unit 108. Assuming the small distance between the second UWB unit 112 and the first battery cell 116, it can be assumed that the first battery cell 116 influences the transmission of the first UWB signal 120. The influencing of the transmission of the first UWB signal 120 changes depending on the geometric shape, density, and/or other mechanical properties of the first battery cell 116. Against this background, the first control module 102, particularly the associated first control unit 106, may be configured to determine a first deformation of the battery 118, particularly related to a deformation of the first battery cell 116, based on the first channel impulse response 134 and the first reference channel impulse response 138.

In an example, the first control module 102, in particular the associated first control unit 106, is configured to compare the first channel impulse response 134 with the first reference channel impulse response 138 to produce a first comparison result. For performing the comparison, the first control module 102, in particular the associated first control unit 106, may be configured to determine a difference value between the signal strength of the first reference channel impulse response 138 at the respective reception time and the signal strength of the first channel impulse response 134 at the corresponding reception time for each reception time (CIR bin) of the first reference channel impulse response 138. Based on the plurality of reception times, a corresponding number of difference values are obtained, such that the plurality of difference values may form the first comparison result.

In an example, the first control module 102, in particular the corresponding first control unit 106, is configured to determine the first deformation of the battery 118, in particular the first deformation of the first battery cell 116 of the first battery 118, based on the first comparison result. The first comparison result may be represented in Figure 4 by the first difference 142.

Through research, it was found that an impulse reflected along the second transmission path 122 at least one reflection location 178 of the first battery cell 116 and thereafter received by the first UWB unit 108 is more indicative of a possible first deformation than an impulse received along the first transmission path 121 prior without reflections from the first UWB unit 108. Which signal path 121, 122 serves to transmit a particularly informative impulse in an actual setup of the system 100 may depend on the particular arrangement of the battery 118, the first control module 102, and/or the second control module 104. The arrangement of the two control modules 102, 104 and the battery 118 may vary, particularly in practical use of the system 100, such as in an vehicle.

In an example, a first machine learning network, which may also be referred to as a first ML network, may be implemented in the first control module 102, in particular in the associated first control unit 106. The first ML network is particularly pre-trained with training reference channel impulse responses and training channel impulse responses. The first control module 102, particularly the associated first control unit 106, may be configured to provide the first channel impulse response 134 and the first reference channel impulse response 138 to the first ML network. Further, the first control module 102, particularly the associated first control unit 106, may be configured to determine the first deformation of the battery 118 via the first ML network based on the provided first channel impulse response 134 and the provided first reference channel impulse response 138. In an example, the first ML network may be pre-trained such that a signal strength difference 142 in the region between the 21st reception time (CIR bin) and the 30^{th} reception time (CIR bin) are particularly influential, and thus are to be weighted higher, than a signal strength difference 162 in any of the other reception times. The ML network may be adaptively pre-trained to the respective arrangement of the first control module 102, the second control module 104, and the battery 118 via the training reference channel impulse responses and the training channel impulse responses. Via the ML network, the first control module 102, in particular the associated first control unit 106, can determine the first deformation of the battery 118, in particular the associated first battery cell 116, particularly precisely and/or adapted to the circumstances.

In an example, the first control module 102, in particular the associated first control unit 106, may be configured to determine a quantitative value of the first deformation of the battery 118, in particular the associated first battery cell 116 based on the first channel impulse response 134 and the first reference channel impulse response 138. The first deformation may have the quantitative value in this example. The smaller the deformation of the battery 118, in particular the associated first battery cell 116, the smaller the quantitative value of the first deformation. The lower limit for the quantitative value may be zero if there is no deformation of the battery 118, in particular the associated first battery cell 116. The greater the quantitative value, the greater the deformation of the battery 118, in particular the associated first battery cell 116. In an example, the first control module 102, in particular the associated first control unit 106, may be configured to determine the quantitative value of the first deformation based on the first difference 142. In an example, the first control module 102, in particular the associated first control unit 106, may be configured to determine the first difference 142 as the maximum difference between the first channel impulse response 134 and the first reference channel impulse response 138. Particularly, the difference is referred to as the difference between the signal strength of the first channel impulse response 134 and the signal strength of the first reference channel impulse response 138 at the same reception time (CIR bin). A corresponding plurality of differences may be determined for the plurality of reception times. The first control module 102 and/or the first control unit 106 may be configured to determine the plurality of differences. Further, the first control module 102 and/or the first control unit 106 may be configured to determine the maximum difference from the plurality of differences. The maximum difference among the determined differences may form the first difference 142. The first control module 102 and/or the first control unit 106 may be configured to use the previously determined maximum difference or the first difference to determine the quantitative value of the first deformation of the battery 118, particularly the associated first battery cell 116.

In an example, the first control module 102, in particular the associated first control unit 106, is configured to identify the battery 118, in particular the associated first battery cell 116, as being in a first state if the determined first deformation is less than a predefined first reference deformation. The first reference deformation may be predefined by practical investigations. In the aforementioned example, the first deformation may refer to a quantitative value of the deformation. Furthermore, the first control module 102, in particular the associated first control unit 106, may be configured to identify the battery 118, in particular the associated battery cells 116, as being in a second state if the determined first deformation is greater than the predefined first reference deformation. If the battery 118 is in the first state, it can be assumed that a geometric shape and/or mechanical structure of the battery 118 has not been altered by external mechanical action. If the battery 118 is in the first state, it may be assumed that the geometric shape and/or mechanical structure of the battery 118 is unchanged. If the battery 118 is in the second state, it may be assumed that a mechanical action, in particular an external mechanical action, has resulted in a geometric shape change and/or mechanical structure change of the battery 118. If the battery is in the second state, it may be assumed that a relevant change in the geometric shape and/or mechanical structure of the battery 118 has occurred. The preceding explanations may apply in an analogous manner to the first battery cell 116 of the battery 118.

The preceding explanations have referred to an example in which the first deformation may represent a quantitative value. In another example that has also been previously explained, it may be assumed that the first deformation represents a qualitative value, such as "not deformed" or "deformed". The preceding explanations reference to the first state and the second state may apply in an analogous manner to the example in which the first deformation represents a qualitative value. Therefore, the first control module 102, in particular the associated first control unit 106, may be configured to identify the battery 118, in particular the associated first battery cells 116, as being in the first state if the determined first deformation represents a first qualitative deformation, such as "not deformed". Further, the first control module 102, in particular the first associated control unit 106, may be configured to identify the battery 118, in particular the associated it battery cells 116, as being in the second state if the determined first deformation represents a second qualitative deformation, such as "deformed".

In an example, the first control module 102, particularly the first control unit 106, is configured to generate a signal referred to as a first error signal if the second state is identified. In an example, the identification of the second state may trigger the generation of the first error signal. The error signal may represent that the battery 118, in particular the associated first battery cell 116, is deformed, in particular more than permissibly deformed. The first control module 102 may be configured to transmit the first error signal to a supervisory module (not shown), in particular a supervisory control module. In an example, the first control module 106 may be configured to control the first UWB module 108 to transmit the first error signal as a UWB signal to the supervisory control module.

In an example, the first control module 102 may comprise at least one wired communication unit 146, 148, such as a controller area network, CAN, communication unit 146 and/or an Ethernet communication unit 148. A CAN protocol, an Ethernet protocol, or another wired communication protocol may be implemented by the wired communication unit 146, 148. For example, CAN communication unit 146 may have implemented the CAN protocol. For example, the CAN protocol comprises Classic CAN, CAN FD, and/or CAN XL. For example, the Ethernet communication unit 148 may have implemented an Ethernet protocol, such as for 10BaseT1S.

The first control unit 106 may be coupled to the CAN communication unit 146 via a signal connection 160. In an example, the first control unit 106 may be configured to control the CAN communication unit 146 via the signal connection 160. In another example, the first control unit 106 may be configured to control the CAN communication unit 146 to transmit the first error signal as a CAN signal to the supervisory control module via the CAN communication unit 146.

The first control unit 106 may be coupled to the Ethernet communication unit 148 via another signal connection 162. In an example, the first control unit 106 may be configured to control the Ethernet communication unit via the signal connection 162. In another example, the first control unit 106 may be configured to control the Ethernet communication unit 148 to transmit the first error signal as an Ethernet signal to the supervisory control module via the Ethernet communication unit 148.

In general, the system 100 may be suitable for many different applications where batteries are used to store energy. Another example of the present disclosure may be a vehicle having the system 100. The vehicle may comprise both the system 100 and the battery 118. In an example, the battery 118 comprises a plurality of battery cells 116, 172. The second control module 104, in particular the associated second control unit 110, may be coupled to the first battery cells 116 of the battery 118. The first control module may be coupled to a communication network of the vehicle via the wired communication unit 146, 148. The third control module 144, in particular the associated third control unit 168, may be coupled to the second battery cells 172 of the battery 118.

As the vehicle is manufactured, the installation location of the first control module 102, the second control module 104, the battery 118, and particularly the third control module 144 are finalized. At the end of the vehicle manufacturing process, in an example, the first reference channel impulse response 138 may be determined and stored by the first control module 102. In this regard, reference is made to the preceding discussion, preferred features and advantages in connection with of the reference UWB signal 176 in an analogous manner.

In an example, the first control module 102 and the second control module 104 are configured to transmit the reference UWB signal 176 from the second UWB unit 112 to the first UWB unit 108. The reference UWB signal 176 may represent a data frame referred to as a reference data frame. In an example, the reference data frame may represent the same first component represented by the first UWB signal 120. For example, the reference data frame may comprise at least the first predefined synchronization field 126, the first SFD field 128, and/or particularly the first STS field 132. The reference data frame need not necessarily comprise a data field 130. Therefore, in an example, the reference data frame may not comprise a data field. Rather, in an example, the reference data frame may exclusively comprise the first synchronization field 126, the first SFD field 128, and particularly the first STS field 132. The first control module 102, in particular the associated first control unit 106, may be configured to determine the first reference channel impulse response 138 based on a component of the received reference UWB signal 176 referred to as the reference component. The reference component may be identical to the first component of the first UWB signal 120. In an example, the reference component may represent at least one symbol of at least one of the following fields: the first synchronization field 126, the first SFD field 128, and particularly the first STS field 132. Further, the first control module 102, particularly the first control unit 106, may be configured to store the first reference channel impulse response. Reference is made in an analogous manner to the advantageous explanations, preferred features, technical effects, and advantages as previously explained in connection with the reference UWB signal 176 and/or the first reference channel impulse response. No repetition is provided.

In an example, the system 100 comprises another control module 144, referred to as the third control module 144. The third control module 144 may be identical to the second control module 104. However, the third control module 144 is not coupled to the first battery cell 116, but may be coupled to a second battery cell 172. Furthermore, in an example, the system 100 may comprise at least one further control module that is identical to the second control module 104. Each additional control module, such as the third control module 144, may be associated with a dedicated battery cell 172 of the battery 118. As a result, each battery cell 116, 172 of the battery 118 may be coupled to exactly one associated control module 104, 144. For each additional control module 144, reference is particularly made to the preceding explanations, preferred features, technical effects and/or advantages in an analogous manner as explained for the second control module 104.

In an example, the system 100 comprises the first control module 102, the second control module 104, and the third control module 144. The third control module 144 may be identical to the second control module 104. The second control module 104 may form a cell control module referred to as the second cell control module 104. The second cell control module 104 comprises the second control unit 110 and the second UWB unit 112. The second control unit 110 may be coupled to the second battery cell 116. The third control module 144 may form another cell control module, referred to as the third cell control module 144. The third cell control module 144 comprises the control unit referred to as the third control unit 166. The third control unit 166 may be identical to the second control unit 110. The third control unit 166 is configured such that the third control unit 166 may be coupled to the second battery cell 172, particularly via the at least one signal connection 184. For the third control unit 166, reference is made to the preceding explanations, preferred features, technical effects and advantages in an analogous manner as explained for the second control unit 110. The third control module 144 comprises the UWB unit referred to as the third UWB unit 168. The third UWB unit 168 may comprise the third antenna 170. The third UWB unit 168 may be identical to the second UWB unit 112. For the third UWB unit 168, reference is made to the preceding explanations, preferred features, technical effect and advantages in an analogous manner as explained for the second UWB unit 112. It should be noted, however, that the third UWB unit 168 does not transmit the first UWB signal 120 to the first UWB unit 108. In contrast, the first control module 102 and the third control module 144 are configured to transmit a second UWB signal 186 from the third UWB unit 168 of the third control module 144 to the first UWB unit 108 of the first control module 102. For the second UWB signal 186, reference is made to the preceding explanations, preferred features, technical effects and advantages in an analogous manner as explained for the first UWB signal 120. The second UWB signal 186 may represent a second data frame comprising at least a second predefined synchronization field, a second predefined SFD field, a second payload data field, and particularly a second STS field. The first control module 102 may be configured to determine a second channel impulse response based on a component, referred to as a second component, of the received second UWB signal 186. The second component of the second UWB signal 186 may be analogous to the first component of the first UWB signal 186. Therefore, for the second component of the second UWB signal 186, reference is made to the preceding explanations, preferred features, technical effect, and advantages in an analogous manner as explained for the first component of the first UWB signal 120. The second component may represent at least one symbol of at least one of the following fields: second synchronization field, second SFD field, and particularly second STS field. In an example, the first control module 102 may store a second reference channel impulse response. For the second reference channel impulse response and/or the configuration of the first control module 102 to determine the second reference channel impulse response, reference is made to the preceding explanations, preferred features, technical effects and advantages in an analogous manner as explained for the first reference channel impulse response and/or the configuration of the first control module 102 to determine the first reference channel impulse response. Further, the first control module 102 may be configured to determine a second deformation of the battery 118, in particular the associated second battery cell 172, based on the second channel impulse response and the second reference channel impulse response. For determining the second deformation, reference is made to the preceding explanations, preferred features, technical effects, and advantages in an analogous manner as explained for determining the first deformation. In an example, the first control module 102, particularly the associated first control unit 106, may be configured to determine the first deformation of the first battery cell 116 of the battery 118 based on the first channel impulse response and the first reference channel impulse response. Further, the first control module 102, in particular the associated first control unit 106, may be configured to determine a second deformation of the second battery cells 172 of the battery 118 based on the second channel impulse response and a second reference channel impulse response. As a result, in an example, the first control module 102, particularly the associated first control unit 106, can determine both the first deformation and the second deformation.

In an example, the system 100 comprises a plurality of further control modules, such as the second control module 104 and/or the third control module 144. In an example, the first control module 102 may establish a dedicated UWB signal connection 120, 186 to each further control module 104, 144. Given the multiple UWB signal connections, it is possible via the first control module 102 to determine possible deformations of a corresponding plurality of battery cells 116, 172. As a result, the deformation of the battery 118 can be subdivided into individual deformations per battery cells 116, 172.

By determining the first deformation and the second deformation via the first control module 102, in particular the associated first control unit 106, it is possible to more easily and precisely locate a deformation in the battery 118. Furthermore, if multiple deformations are determined for the battery 118, a plausibility check can be performed via the first control module 102, in particular the associated first control unit 106. In an example, the first control module 102, in particular the associated first control unit 106, may be configured to reject the first and/or second deformations if the first deformation differs from the second deformation by more than a predefined value referred to as a deformation threshold. As an effect, the first and second deformations may be considered plausible if the first and second deformations differ by less than the predefined deformation threshold.

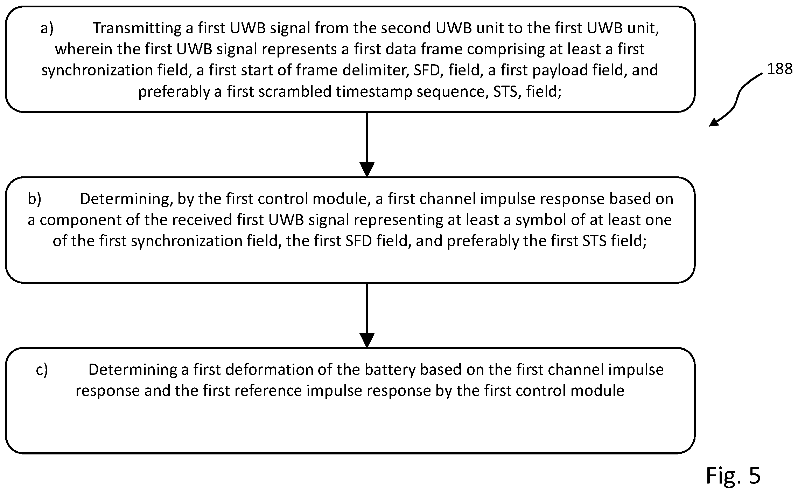

Referring to Figure 5, an example of a method 188 for the system 100 is schematically illustrated. Particularly, the method 188 comprises the following steps:
a) Transmitting a first UWB signal 102 from the second UWB unit 112 to the first UWB unit 108, wherein the first UWB signal 120 represents a first data frame 124 comprising at least a first synchronization field 126, a first start of frame delimiter, SFD, field 128, a first payload field 130, and particularly a first scrambled timestamp sequence, STS, field 132;
b) Determining, by the first control module 102, a first channel impulse response 134 based on a component of the received first UWB signal 120 representing at least a symbol 136 of at least one of the first synchronization field 126, the first SFD field 128, and particularly the first STS field 132; and
c) Determining a first deformation of the battery 118 based on the first channel impulse response 134 and the first reference impulse response 138 by the first control module 102.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. System, comprising:
a first control module and a second control module,
wherein the first control module comprises a first control unit and an ultra wideband communication unit, referred to as a first UWB unit,
wherein the second control module comprises a second control unit and an ultra wideband communication unit, referred to as a second UWB unit,
wherein one of the control modules is referred to as a cell control module and is configured such that the associated control unit can be coupled to a first battery cell of a battery to monitor and/or control the voltage and/or temperature of the battery cell,
wherein the second control module is configured to transmit a first ultra wideband radio signal, referred to as first UWB signal, from the second UWB unit to the first UWB unit,
wherein the first UWB signal represents a first data frame comprising at least a first predefined synchronization field, a first predefined start of frame delimiter, SFD, field, a first payload field, and particularly a first scrambled timestamp sequence, STS, field,
wherein the first control module is configured to determine a first channel impulse response, CIR, based on a component of the received first UWB signal representing at least one symbol of at least one of the first synchronization field, the first SFD field, and particularly the first STS field,
wherein a first reference CIR is stored by the first control module, and
wherein the first control module is configured to determine a first deformation of the battery based on the first CIR and the first reference CIR.

2. The system according to the preceding claim, wherein the first deformation of the battery refers to a deflection of the battery, a twisting of the battery, a concave or convex deformation of an outer side of the battery, and/or a volume change of the battery.

3. The system according to any of the preceding claims, wherein the first control module is configured to compare the first CIR with the first reference CIR resulting in a first comparison result, and wherein the first control module is configured to determine the first deformation of the battery based on the first comparison result.

4. The system according to the preceding claim, wherein the first control module is configured to determine a first difference between the first CIR and the first reference CIR, and to determine the first deformation of the battery based on the first difference.

5. The system according to any of the preceding claims, wherein a first machine learning, ML, network is implemented to the first control module, the first ML network being pre-trained with training reference impulse responses and training impulse responses to determine training deformations of the battery, respectively, wherein the first control module is configured to supply the first CIR and the first reference CIR to the first ML network and to determine the first deformation of the battery via the first ML network based on the supplied first CIR and the supplied first reference CIR.

6. The system according to any of the preceding claims, wherein the first control module is configured to identify the battery as being in a first state if the determined first deformation is less than a predefined first reference deformation, and wherein the first control module is configured to identify the battery as being in a second state if the determined first deformation is greater than the predefined first reference deformation.

7. The system according to the preceding claim, wherein the first control module is configured to generate a signal referred to as a first error signal if the second condition is identified, and wherein the first control module is configured to transmit the first error signal to a supervisory control module via the first UWB unit.

8. A system according to any of the preceding claims,
wherein the second control module is configured to transmit another UWB signal, referred to as a reference UWB signal, from the second UWB unit to the first UWB unit,
wherein the reference UWB signal represents a data frame referred to as a reference data frame, which comprises at least the first predefined synchronization field and/or the first SFD field and/or particularly the first STS field,
wherein the first control module is configured to determine the first reference CIR based on a component of the received reference UWB signal representing at least one symbol of at least one of the first synchronization field, the first SFD field and particularly the first STS field, and
wherein the first control module is configured to store the first reference CIR.

9. The system according to any of the preceding claims, wherein the second control module forms the cell control module.

10. The system according to any of the preceding claims 1 to 8,
wherein the system comprises a third control module being particularly identical to the second control module,
wherein the second control module forms a cell control module referred to as a second cell control module, which comprises the second control unit being adapted to be coupled to a first battery cell of the battery,
wherein the third control module forms another cell control module referred to as a third cell control module, which comprises a third control unit being adapted to be coupled to a second battery cell of the battery,
wherein the first control module and third control module are configured to transmit a second UWB signal from the third UWB unit of the third control modules to the first UWB unit of the first control module,
wherein the second UWB signal represents a second data frame comprising at least a second predefined synchronization field, a second predefined SFD field, a second payload field, and particularly a second STS field,
wherein the first control module is configured to determine a second CIR based on a component of the received second UWB signal representing at least a symbol of at least one of the second synchronization field, the second SFD field, and particularly the second STS field,
wherein a second reference CIR is stored by the first control module, and
wherein the first control module is configured to determine a second deformation of the battery based on the second CIR and the second reference CIR.

11. The system according to the preceding claim, wherein the first control module is configured to discard the first deformation if the first deformation deviates from the second deformation by more than a predefined deformation threshold.

12. A system according to any of the preceding claims, wherein the first control module comprises a wired communication unit.

13. System according to the preceding claim, wherein a CAN protocol, an Ethernet protocol, or another wired communication protocol is implemented by the wired communication unit.

14. A system according to any of the preceding claims, wherein the system comprises the battery.

15. A method for a system comprising a first control module and a second control module, the first control module comprising a first control unit and an ultra wideband communication unit referred to as a first UWB unit, the second control module comprising a second control unit and an ultra wideband communication unit, referred to as a second UWB unit, wherein one of the control modules is referred to as a cell control module and is configured so that the associated control unit can be coupled to a first battery cell of a battery, wherein a first reference impulse response is stored by the first control module, and wherein the method comprises the steps of:
a) Transmitting a first UWB signal from the second UWB unit to the first UWB unit, wherein the first UWB signal represents a first data frame comprising at least a first synchronization field, a first start of frame delimiter, SFD, field, a first payload field, and particularly a first scrambled timestamp sequence, STS, field;
b) Determining, by the first control module, a first channel impulse response based on a component of the received first UWB signal representing at least a symbol of at least one of the first synchronization field, the first SFD field, and particularly the first STS field; and
c) Determining a first deformation of the battery based on the first channel impulse response and the first reference impulse response by the first control module.
